# EUROPEAN PATENT SPECIFICATION

(11) **EP 0 496 127 B1**
(45) Date of publication and mention of the grant of the patent: **10.09.1997**
(21) Application number: 91200133.6
(22) Date of filing: 24.01.1991
(51) Int. Cl.: G03F 7/07

(54) **A negative type lithographic printing plate based on silver salt diffusion transfer**
Flachdruckplatte vom Negativtyp auf Silbersalzdiffusionübertragungsbasis
Plaque d'impression lithographique de type négatif basé sur le transfert de diffusion de sel d'argent

(43) Date of publication of application: 29.07.1992
(73) Proprietor: AGFA-GEVAERT naamloze vennootschap, 2640 Mortsel (BE)
(72) Inventor: Van Rompuy, Ludo Laura, B-9070 Destelbergen (BE); Borginon, Hendrik Alfons, B-2640 Mortsel (BE)

(56) References cited:
- US-A- 4 149 889
- US-A- 4 772 535

## Description

### 1. Field of the invention.

The present invention relates to a negative type diffusion transfer imaging element and to a method for obtaining a negative type lithographic printing plate therewith.

### 2. Background of the invention.

The principles of the silver complex diffusion transfer reversal process, hereinafter called DTR-process, have been described e.g. in US-P-2352014 and the book "Photographic Silver Halide Diffusion Processes" by André Rott and Edith Weyde - The Focal Press -London and New York, (1972).

According to the DTR process, a silver complex salt is image-wise transferred by diffusion from the image-wise exposed silver halide emulsion layer into the image receiving layer, where it is converted to a silver image usually in the presence of physical development nuclei. For this purpose, the image-wise exposed silver halide emulsion layer is developed in the presence of a developing agent and non-developed silver halide is converted by means of a silver halide complexing agent into a soluble silver complex salt while in contact with an image receiving layer.

The DTR process includes (a) a so-called "two-sheet" type where the silver halide emulsion layer and the image receiving layer are contained on separate supports and are brought into contact with each other at the time of diffusion transfer development to produce the silver image in the receiving sheet and (b) a so-called "mono-sheet" type where both the emulsion layer and the layer containing the physical development nuclei are contained on the same support.

In the conventional negative-positive DTR-process a negative image is formed in the silver halide emulsion layer while a positive image is formed in the receiving layer. The term negative image means that image reversal occurs while the term positive image indicates that no image reversal took place.

At the exposed areas of the silver halide emulsion layer the silver halide is developed (chemical development) and thus cannot be dissolved anymore to diffuse to the receiving layer.

At the unexposed areas of the silver halide emulsion layer the silver halide is converted into a soluble silver complex salt and is transferred to the receiving layer, where it forms a silver image usually in the presence of physical development nuclei.

If a negative image of the original is to be formed in the receiving layer a positive image should be formed in the silver halide emulsion layer and the DTR process is then of the positive-negative type. The formation of negative images from the original are interesting where positive DTR-images are desired from negative originals. This requires the use of light-sensitive silver halide emulsion materials which upon exposure and development form direct positive images i.e. the formation of a silver image in the non-exposed areas.

It is further known to make lithographic printing plates by the DTR-process.

Printing plates made by the conventional DTR-process are of the positive type and thus the conventional DTR-process cannot be used to obtain a positive printing plate starting from negative originals.

Furthermore the conventional positive type DTR-process for direct plate making by lasers and scanners e.g. computer to plate applications which are recently widely employed, have the disadvantage of requiring a lot of exposure time since the non-image areas of the negative silver halide emulsion layer should be exposed in order to obtain in the image receiving layer image areas that are printing. Thus for computer to plate applications it is also desirable to have a silver halide emulsion layer forming a silver image in the non-exposed areas so that silver complexes from the exposed areas are transferred to form the oleophilic printing areas in the image receiving layer.

For the formation of a direct-positive image in the silver halide emulsion layer two main types of direct positive type silver halide emulsions are known.

One type is a silver halide emulsion that has previously been fogged. Such types of emulsion are commonly known as Herschel reversal emulsions and are described in e.g. US-P-3367778. US-P-3733199 discloses the use of such a type of emulsion for use in a diffusion transfer process. US-P-4149889 and US-P-4175965 describe the use of Herschel reversal emulsions for the production of a negative type lithographic printing plate.

The second type of direct positive type emulsions are inner latent image type silver halide emulsions that have not been previously fogged. A direct positive image in the emulsion layer is obtained by effecting surface development after or while applying a fogging treatment subsequent to image-wise exposure. The fogging treatment may be performed by giving the whole surface an overall exposure, by chemical treatment using a foggant, or alternatively by use of a strong developer or heat treatment etc., but ordinarily the method by use of light and/or foggant is employed. The inner latent image type silver halide photographic emulsion refers to a silver halide photographic emulsion, having light-sensitive nuclei primarily internally of the silver halide grains which forms latent images internally of the grains by exposure. Such a type of direct positive emulsions is disclosed in e.g. EP-A-365926. US-4309499 discloses its use in a DTR imaging element. This type of direct positive emulsion shows a higher speed than the above first type.

The speed of a direct positive type emulsion can be further increased when the emulsion contains large amounts of bromide. However processing of a DTR imaging element containing a direct positive type emulsion, not previously fogged, containing large amounts of bromide, with a transfer developer containing a solvent for silver halide, e.g. thiocyanate does not result in a silver mirror sufficiently strong for producing a lithographic printing plate of high printing endurance.

It is an object of the present invention to provide a method for obtaining a lithographic printing plate of high printing endurance using a DTR imaging element of high speed comprising a direct positive silver halide emulsion.

It is a further object of the present invention to provide an imaging element comprising a direct positive silver halide emulsion for producing a lithographic printing plate of high printing endurance.

### 3. Summary of the invention.

According to the present invention there is provided an imaging element comprising on a support (i) a layer of a direct positive silver halide emulsion and (ii) a substantially non-light sensitive layer containing a silver salt and (iii) a layer of physical development nuclei, the said layer (i) being provided between layers (ii) and (iii). characterized in that said imaging element additionally comprises a hydrophylic layer between said direct positive silver halide emulsion layer and said substantially non-light sensitive layer and/or a hydrophilic layer between said direct positive silver halide emulsion layer and said layer of physical development nuclei.

According to the present invention there is provided a method for obtaining a lithographic printing plate comprising the steps of:
- image-wise exposing an imaging element comprising on a support (i) a layer of a direct positive type silver halide emulsion, (ii) a substantially non-light sensitive layer containing a silver salt, (iii) a layer of physical development nuclei, the said layer (i) being provided between layers (ii) and (iii), and (iv) a hydrophilic layer between said layer of a direct positive silver halide emulsion and said substantially non-light sensitive layer containing a silver salt and/or a hydrophilic layer between said layer of a direct positive silver halide emulsion and said layer of physical development nuclei,
- developing said image-wise exposed imaging element,
- dissolving said non-light sensitive silver salts by means of (a) silver complexing agent(s),
- allowing the thus formed silver complexes to diffuse to said layer of physical development nuclei,
- and depositing said silver complexes in said layer of physical development nuclei.

### 4. Detailed description of the invention.

Suitable direct positive silver halide emulsions for use in accordance with the present invention are silver halide emulsions that have been previously fogged or that mainly form an internal latent image as referred to hereinbefore.

An internal latent image-type silver halide emulsion is an emulsion, the maximum density of which obtained when developing it with an "internal type" developing solution exceeds the maximum density that is achievable when developing it with a "surface-type" developing solution. The internal latent image-type emulsions that are suited for use in accordance with the present invention yield a maximum density that, when these emulsions have been coated on a transparent support and are exposed to light for a fixed time of from 1/100 to 1 s and then developed for 3 min at 20°C with the internal-type Developing Solution A as described hereinafter, at least 5 times larger than the maximum density obtained when the same silver halide emulsion coated and exposed as described above is developed for 4 min at 20°C with the surface-type Developing Solution B as described hereinafter.

| Internal-type Developing Solution A | |
|---|---|
| hydroquinone | 15 g |
| monomethyl-p-aminophenol sulphate | 15 g |
| anhydrous sodium sulphite | 50 g |
| potassium bromide | 10 g |
| sodium hydroxide | 25 g |
| crystalline sodium thiosulphate | 20 g |
| Water to make | 1 l |

| Surface-type Developing Solution B | |
|---|---|
| p-hydroxyphenylglycine | 10 g |
| crystalline sodium carbonate | 100 g |
| water to make | 1 l |

Internal latent image-type silver halide emulsions that can be used in accordance with the present invention have been described in e.g. US-A 2,592,250, 3,206,313, 3,271,157, 3,447,927, 3,511,662, 3,737,313, 3,761,276, GB-A 1,027,146, and JA Patent Publication No. 34,213/77. However, the silver halide emulsions used in the present invention are not limited to the silver halide emulsions described in these documents.

Suitable direct positive emulsions which mainly form internally a latent image are generally emulsions that have not been prefogged and have not been chemically ripened or only slightly, since the ability to form a surface latent image increases with the degree of chemical ripening. Silver chlorobromide emulsions comprising at least 20 mol% of silver bromide and pure silver bromide are particularly suited for use as internal latent image emulsion in accordance with the present invention. Silver chlorobromide emulsions or silver bromide emulsions containing up to 5 mol % silver iodide are also suitable for use with the present invention. Said direct positive emulsions may be so called conversion type emulsions or core-shell emulsions.

The direct positive emulsion may be prepared by techniques conventional for photographic emulsion preparation as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966). The photographic silver halide emulsions used in the method of the present invention can be prepared by mixing the halide and silver solutions in partially or fully controlled conditions of temperature, concentrations, sequence of addition, and rates of addition. The silver halide can be precipitated according to the single-jet method, the double-jet method etc..

A preparation method which has proved to be particularly suitable is the so called conversion method. According to this method a more soluble silver halide is converted in a less soluble silver halide, e.g., a silver chloride emulsion is converted in the presence of water soluble bromide and possibly iodide, the amounts of which are selected with regard to the final composition, into a silver chlorobromide or silver bromide emulsion, which may also include a small amount of iodide. This conversion is preferably carried out very slowly in several consecutive steps, i.e. by converting a part of the more soluble silver halide at a time. A more detailed description of the preparation of such direct positive emulsion can be found in the examples of GB-PS-1195837. Another technique by which such direct positive emulsions may be prepared is described in GB-PS-1011062.

The other type of direct positive type silver halide emulsions for use in accordance with the present invention, which is of the previously fogged type, may be prepared by overall exposing a silver halide emulsion to light and/or by chemically fogging a silver halide emulsion. Chemical fog specks may be formed by various methods for chemical sensitization.

Chemical fogging may be carried out by reduction or by a compound which is more electropositive than silver e.g. gold salts, platinum salts, iridium salts etc., or a combination of both. Reduction fogging of the silver halide grains may occur by high pH and/or low pAg silver halide precipitation or digestion conditions e.g. as described by Wood J. Phot. Sci. 1 (1953), 163 or by treatment with reducing agents e.g. tin(II) salts which include tin(II)chloride, tin complexes and tin chelates of (poly)amino(poly)carboxilic acid type as described in British Patent 1,209,050 , formaldehyde, hydrazine, hydroxylamine, sulphur compounds e.g. thiourea dioxide, phosphonium salts e.g. tetra(hydroxymethyl)-phosphonium chloride, polyamines e.g. diethylenetriamine, bis(p-aminoethyl)sulphide and its water-soluble salts, hydrazine derivatives, alkali arsenite, amine borane etc. or mixtures thereof.

When fogging of the silver halide grains occurs by means of a reducing agent e.g. thiourea dioxide and a compound of a metal more electropositive than silver especially a gold compound, the reducing agent is preferably used initially and the gold compound subsequently. However, the reverse order can be used or both compounds can be used simultaneously.

In addition to the above described methods of chemically fogging chemical fogging can be attained by using said fogging agents in combination with a sulphur-containing sensitizer, e.g. sodium thiosulphate or a thiocyanic acid compound e.g. potassium thiocyanate.

Direct positive type silver halide emulsions previously fogged for use in accordance with the present invention may comprise interior electron-traps or exterior electron traps. Fogged direct positive silver halide emulsions with interior electron traps are emulsions comprising silver halide grains having their interior centers promoting the deposition of photolytic silver and an outer region of fogged silver halide. Fogged direct-positive silver halide emulsions with exterior electron-traps are emulsions having absorbed to the surface of the fogged silver halide grains a compound accepting electrons e.g. electron-accepting dyes which may provide spectral sensitization or not or desensitizing compounds as described in e.g. the British Patent Specification 723,019.

According to Sheppard et al. J. Phys. Chem; 50 (1946) 210 desensitizers are dyestuffs whose cathodic polarographic half-wave potential, measured against the calomel electrode, is more positive than -1.0V. It is well kown to characterize these electron-accepting or desensitizing compounds by means of their polarographic half-wave potential. Electron acceptors suitable for use in the direct-positive silver halide emulsions of the present invention have an anodic polarographic half-wave potential and a cathodic half-wave potential that when added together give a positive sum. Methods of determining these polarographic half-wave potentials have been described, e.g., in the US-P-3,501,310 and US-P-3,531,290.

The direct positive prefogged silver halide emulsion layer comprised on the imaging element of the present invention may be any type of direct positive silver halide emulsion layer. The halide composition of the silver halide emulsion used according to the present invention is not specifically limited and may be any composition selected from i.a. silver chloride, silver bromide, silver iodide, silver chlorobromide, silver bromoiodide, and silver chlorobromoiodide. The content of silver iodide is equal to or less than 20 mol%, preferably equal to or less than 5 mol%, even more preferably equal to or less than 3 mol%. A preferably used silver halide emulsion contains at least 30 mol% of AgBr.

The silver halide particles of the photographic emulsion used according to the present invention may have a regular crystalline form e.g. a cubic or octahedral form or they may have a transition form. They may also have an irregular crystalline form e.g. a spherical form or a tabular form, or may otherwise have a composite crystal form comprising a mixture of said regular and irregular crystalline forms.

The silver halide grains may have a multilayered grain structure. According to a simple embodiment the grains may comprise a core and a shell, which may have different halide compositions and/or may have undergone different modifications e.g. the addition of dopes. Besides having a differently composed core and shell the silver halide grains may also comprise different phases inbetween.

The size distribution of the silver halide particles of the photographic emulsions to be used according to the present invention can be homodisperse or heterodisperse. A homodisperse size distribution is obtained when 95% of the grains have a size that does not deviate more than 30% from the average grain size.

The silver halide crystals can be doped with Rh³⁺, Ir⁴⁺, Cd²⁺, Zn²⁺, Pb²⁺.

Besides the silver halide another essential component of a light-sensitive emulsion layer is the binder. The binder is a hydrophilic colloid, preferably gelatin. Gelatin can, however, be replaced in part or integrally by synthetic, semi-synthetic, or natural polymers. Synthetic substitutes for gelatin are e.g. polyvinyl alcohol, poly-N-vinyl pyrrolidone, polyvinyl imidazole, polyvinyl pyrazole, polyacrylamide, polyacrylic acid, and derivatives thereof, in particular copolymers thereof. Natural substitutes for gelatin are e.g. other proteins e.g. zein, albumin and casein, cellulose, saccharides, starch, and alginates. In general, the semi-synthetic substitutes for gelatin are modified natural products e.g. gelatin derivatives obtained by conversion of gelatin with alkylating or acylating agents or by grafting of polymerizable monomers on gelatin, and cellulose derivatives e.g. hydroxyalkyl cellulose, carboxymethyl cellulose, phthaloyl cellulose, and cellulose sulphates.

The gelatin can be lime-treated or acid-treated gelatin. The preparation of such gelatin types has been described in e.g. "The Science and Technology of Gelatin", edited by A.G. Ward and A. Courts, Academic Press 1977, page 295 and next pages. The gelatin can also be an enzyme-treated gelatin as described in Bull. Soc. Sci. Phot. Japan, N° 16, page 30 (1966).

The direct positive silver halide emulsions can be spectrally sensitized with methine dyes e.g. those described by F.M. Hamer in "The Cyanine Dyes and Related Compounds", 1964, John Wiley & Sons. Dyes that can be used for the purpose of spectral sensitization include cyanine dyes, merocyanine dyes, complex cyanine dyes, complex merocyanine dyes, holopolar cyanine dyes, hemicyanine dyes, styryl dyes and hemioxonol dyes. Particularly valuable dyes are those belonging to the cyanine dyes, merocyanine dyes, complex merocyanine dyes.

Other dyes, which per se do not have any spectral sensitization activity, or certain other compounds, which do not substantially absorb visible radiation, can have a supersensitization effect when they are incorporated together with said spectral sensitizing agents into the emulsion. Suitable supersensitizers are i.a. heterocyclic mercapto compounds containing at least one electronegative substituent as described e.g. in US-A 3,457,078, nitrogen-containing heterocyclic ring-substituted aminostilbene compounds as described e.g. in US-A 2,933,390 and US-A 3,635,721, aromatic organic acid/formaldehyde condensation products as described e.g. in US-A 3,743,510, cadmium salts, and azaindene compounds.

The silver halide emulsion for use in accordance with the present invention may comprise compounds stabilizing the photographic characteristics during the production or storage of photographic elements or during the photographic treatment thereof. Many known compounds can be added as stabilizer to the silver halide emulsion. Suitable examples are i.a. the heterocyclic nitrogen-containing compounds e.g. benzothiazolium salts, nitroimidazoles, nitrobenzimidazoles, chlorobenzimidazoles, bromobenzimidazoles, mercaptothiazoles, mercaptobenzothiazoles, mercaptobenzimidazoles, mercaptothiadiazoles, aminotriazoles, benzotriazoles (preferably 5-methyl-benzotriazole), nitrobenzotriazoles, mercaptotetrazoles, in particular 1-phenyl-5-mercapto-tetrazole, mercaptopyrimidines, mercaptotriazines, benzothiazoline-2-thione, oxazoline-thione, triazaindenes, tetrazaindenes and pentazaindenes, especially those described by Birr in Z. Wiss. Phot. 47 (1952), pages 2-58, triazolopyrimidines e.g. those described in GB-A 1,203,757, GB-A 1,209,146, JA-Appl. 75-39537, and GB-A 1,500,278, and 7-hydroxy-s-triazolo-[1,5-a]-pyrimidines as described in US-A 4,727,017, and other compounds e.g. benzenethiosulphonic acid, benzenethiosulphinic acid, benzenethiosulphonic acid amide. Stabilizers can be added to the silver halide emulsion prior to, during, or after the ripening thereof and mixtures of two or more of these compounds can be used.

The imaging element of the present invention may further comprise various kinds of surface-active agents in the photographic emulsion layer or in at least one other hydrophilic colloid layer. Suitable surface-active agents include non-ionic agents e.g. saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides, anionic agents comprising an acid group e.g. a carboxy, sulpho, phospho, sulphuric or phosphoric ester group, ampholytic agents e.g. aminoacids, aminoalkyl sulphonic acids, aminoalkyl sulphates or phosphates, alkyl betaines, and amine-N-oxides; and cationic agents e.g. alkylamine salts, aliphatic, aromatic, or heterocyclic quaternary ammonium salts, aliphatic or heterocyclic ring-containing phosphonium or sulphonium salts. Such surface-active agents can be used for various purposes e.g. as coating aids, as compounds preventing electric charges, as compounds improving slidability, as compounds facilitating dispersive emulsification, as compounds preventing or reducing adhesion, and as compounds improving the photographic characteristics e.g. higher contrast, sensitization, and development acceleration.

Development acceleration can be accomplished with the aid of various compounds, preferably polyalkylene derivatives having a molecular weight of at least 400 e.g. those described in e.g. US-A 3,038,805 - 4,038,075 - 4,292,400.

The imaging element of the present invention may further comprise various other additives e.g. compounds improving the dimensional stability of the photographic element, UV-absorbers, spacing agents, hardeners, and plasticizers.

Suitable additives for improving the dimensional stability of the photographic element are i.a. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins , and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

Suitable UV-absorbers are i.a. aryl-substituted benzotriazole compounds as described in US-A 3,533,794, 4-thiazolidone compounds as described in US-A 3,314,794 and 3,352,681, benzophenone compounds as described in JP-A 2784/71, cinnamic ester compounds as described in US-A 3,705,805 and 3,707,375, butadiene compounds as described in US-A 4,045,229, and benzoxazole compounds as described in US-A 3,700,455.

The silver salt particles contained in said substantially non-light-sensitive layer are preferably insoluble in water and are capable of being complexed by a complexing agent present in the diffusion transfer processing liquid. The term "substantially non-light-sensitive layer" means that said layer shows substantially no light-sensitivity towards the light energy necessary to expose the direct positive silver halide emulsion layer and to form a latent image therein.

Preferably the substantially non-light-sensitive layer contains a silver salt that is substantially non-light-sensitive towards the light energy necessary to expose the direct positive silver halide emulsion layer thus rendering the layer containing them non-light-sensitive. Preferred silver salts used according to the invention are water insoluble silver salts e.g. a silver halide, bromate, molubdate, oxalate, chromate, iodate, isocyanate, thioisocyanate, cyanide, citrate phosphate, silver oxide etc.. Said non-light-sensitive water insoluble silver salts may be prepared using the precipitation reaction of the water soluble salt of the desired anion of the insoluble silver salt with a water soluble silver salt, e.g. silver nitrate, in the presence of a hydrophilic binder. Silver halide containing at least 70 mol% of chloride is preferred in the present invention for use as the non-light sensitive water insoluble silver salt. The silver halide is preferably also doped with Rh³⁺, Ir⁴⁺, Cd²⁺, Zn²⁺ or Pb²⁺ to reduce the light sensitivity of the silver halide.

Suitable hydrophilic binders for the substantially non-light-sensitive layer are the above mentioned binders suitable for the direct positive silver halide emulsion.

The imaging element of the present invention further comprises at least a layer of physical development nuclei. Suitable physical development nuclei for use in accordance with the present invention are e.g. colloidal silver, heavy metal sulphides e.g. silver sulphide, nickel sulphide, palladium sulphide, cobalt sulphide, zinc sulphide, silver nickel sulphide etc. The layer of physical development nuclei may contain a hydrophilic binder but preferably does not contain a binder. When a hydrophilic binder is used, those mentioned as binders for the direct positive emulsions can be used.

The support of the imaging element used in accordance with the present invention can be any of the support materials customarily employed in the art. They include metal supports e.g. aluminum or zinc, paper coated on one or both sides with an Alpha-olefin polymer, e.g. polyethylene, glass or film, e.g. cellulose acetate film, polyvinyl acetal film, polystyrene film, polyethylene terephthalate film etc.. Polyethylene terephthalate film coated with a subbing layer to improve the adhesion of the thereon deposited layers of the invention and aluminium are preferred.

Suitable aluminium supports for use in accordance with the present invention are aluminium foils made of pure aluminium or of an aluminium alloy, the aluminium content of which is at least 95%. A useful alloy is e.g. one comprising 99.55% by weight of Al, 0.29% of Fe, 0.10% of Si, 0.004% of Cu, 0.002% of Mn, 0.02% of Ti, and 0.03% of Zn. The thickness of the foil usually ranges from about 0.13 to about 0.50 mm.

The preparation of aluminium or aluminium alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improve the printing results.

Graining of the aluminium surface can be carried out mechanically or electrolytically in any known way. The roughness produced by the graining is measured as a centre line average value expressed in µm and preferably varies from about 0.2 to about 1.5 µm.

The anodization of the aluminium foil can be performed in electrolytes e.g. chromic acid, oxalic acid, sodium carbonate, sodium hydroxide, and mixtures thereof. Preferably, the anodization of the aluminium is performed in dilute aqueous sulphuric acid medium until the desired thickness of the anodization layer is reached. The aluminium foil may be anodized on both sides. The thickness of the anodization layer is most accurately measured by making a micrographic cut but can be determined likewise by dissolving the anodized layer and weighing the plate before dissolution treatment and subsequent thereto. Good results are obtained with an anodization layer thickness of about 0.4 to about 2.0 µm. To promote the image sharpness and, as a consequence thereof, the sharpness of the final printed copy, the anodization layer may be coloured in the mass with an antihalation dye or pigment e.g. as described in JA-A 58-14797. The dye or pigment or a combination of dyes or pigments used for such colouring in the mass are chosen such that they prevent or reduce halation in silver halide emulsions having any desired photosensitivity range comprised between 300 and 900 nm.

After the anodizing step the anodic surface may be sealed. Sealing of the pores of the aluminium oxide layer formed by anodization is a technique known to those skilled in the art of aluminium anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminium". Different types of sealing of the porous anodized aluminium surface exist. The anodic surface of the aluminium foil can be rinsed with water at 70-100°C or with steam. The hot sealing water may comprise additives e.g. nickel salts to improve the sealing effect. The sealing can also be performed by treatment of the anodic surface with an aqueous solution comprising phosphate ions or silicates.

The graining, anodizing, and sealing of the aluminium foil can be performed as described in e.g. US-A 3,861,917 and in the documents referred to therein.

The imaging element of the present invention also contains a hydrophilic layer between the layer of the direct positive silver halide emulsion and the substantially non-light-sensitive layer containing a silver salt and/or a hydrophilic layer between the direct positive silver halide emulsion and the layer containing physical development nuclei. A preferably used hydrophilic layer is a layer of gelatin. Gelatin can, however, be replaced in part or integrally by synthetic, semi-synthetic, or natural polymers. Synthetic substitutes for gelatin are e.g. polyvinyl alcohol, poly-N-vinyl pyrrolidone, polyvinyl imidazole, polyvinyl pyrazole, polyacrylamide, polyacrylic acid, and derivatives thereof, in particular copolymers thereof. Natural substitutes for gelatin are e.g. other proteins e.g. zein, albumin and casein, cellulose, saccharides, starch, and alginates. In general, the semi-synthetic substitutes for gelatin are modified natural products e.g. gelatin derivatives obtained by conversion of gelatin with alkylating or acylating agents or by grafting of polymerizable monomers on gelatin, and cellulose derivatives e.g. hydroxyalkyl cellulose, carboxymethyl cellulose, phthaloyl cellulose, and cellulose sulphates.

The gelatin can be lime-treated or acid-treated gelatin. The preparation of such gelatin types has been described in e.g. "The Science and Technology of Gelatin", edited by A.G. Ward and A. Courts, Academic Press 1977, page 295 and next pages. The gelatin can also be an enzyme-treated gelatin as described in Bull. Soc. Sci. Phot. Japan, N° 16, page 30 (1966).

Said hydrophilic layer may also be a water swellable layer of latex particles of e.g. homo- or copolymers of (meth)acrylates or a mixture of said latex particles and a hydrophilic polymer e.g. polyvinyl alcohol.

The thickness of these intermediate layers is preferably between 0.5 µm and 4 µm.

It was found that a lithographic printing plate produced from an imaging element of the present invention comprising the above described intermediate hydrophilic layer(s) shows a substantially higher printing endurance than in the absence of any of these layers. But even when such layers of the present invention are not comprised on the imaging element, an increase in the printing endurance can be observed with respect to imaging elements comprising a direct positive silver halide emulsion and not comprising the layer of non-light sensitive silver salt particles.

In addition to the above described advantages of the present invention saving of silver can be obtained with the imaging element of the present invention without loss of speed.

According to a first pratical embodiment of the present invention a polyethylene terephthalate film support coated with a subbing layer to improve the adhesion of the subsequent layers is coated as in the order given with a substantially non-light-sensitive layer containing a silver halide, an intermediate layer of gelatin, a light sensitive direct positive type silver halide emulsion, a layer of gelatin and a layer containing physical development nuclei. According to this first pratical embodiment the substantially non-light-sensitive layer may contain a silver halide showing no light-sensitivity towards the light energy neccesary to expose the direct positive silver halide emulsion to render said layer non-light-sensitive.

According to another possibility said substantially non-light-sensitive layer may be rendered non-light-sensitive by providing a layer absorbing the light energy necessary to expose the direct positive silver halide emulsion layer, between the layer to be rendered substantially non-light-sensitive and said direct positive silver halide emulsion layer. When such a light absorbing layer is provided between said direct positive silver halide emulsion layer and the layer to be rendered non-light-sensitive, it will be clear that the silver halide contained in the latter layer may be light-sensitive.

Suitable light absorbing layers for use in accordance with the present invention are layers comprising a dye or dye pigment which absorbs the light energy necessary to expose the direct positive silver halide emulsion layer. Preferably the light absorbing layer is the hydrophilic layer provided between the direct positive silver halide emulsion layer and the substantially non-light-sensitive layer.

According to a second pratical embodiment of the present invention an aluminium support grained and anodized as described above is provided in the order given with a layer containing physical development nuclei, a hydrophilic layer, a light sensitive direct positive type silver halide emulsion layer, a non-light sensitive silver halide emulsion layer. Said hydrophilic layer preferably is a layer of polyvinyl alcohol, a water swellable layer of latex particles or a mixture thereof.

The imaging element of this second embodiment can be made by coating on a grained and anodized aluminium support provided with a layer of physical development nuclei said hydrophilic layer and coating the intermediate layer with a light-sensitive direct positive type silver halide emulsion layer and subsequently thereon a non-light sentive silver halide emulsion layer.

According to another method said imaging element can be prepared by the following steps :
- coating a temporary base in the order given with a non-light sensitive silver halide emulsion layer and a direct positive type silver halide emulsion,
- coating the thus obtained element with a hydrophylic layer and
- pressing the thus formed photosensitive layer packet with its side carrying said hydrophylic layer against the surface of the aluminium support carrying a layer of physical development nuclei and which has been wetted with an aqueous moistening liquid, the temporary base being removed before or after photo-exposure.

Suitable temporary bases for use in accordance with the present invention are e.g. polyethylene terephthalate film or triacetate film.

The present invention also provides a method for obtaining a lithographic printing plate from the above described imaging element of the present invention. According to this method the imaging element is image-wise exposed and subsequently developed.

Development is preferably done using two developing baths the first of which contains only a small amount of a silver halide complexing agent and most preferably does not contain a silver halide complexing agent. The first developing bath thus serves as a developing liquid for the image-wise exposed direct positive silver halide emulsion without transferring silver salts from the direct positive silver halide emulsion or the layer containing the non-light sensitive silver salts.

The composition of the first applied developing bath further depends on the type of direct positive silver halide emulsion used.

When the direct positive silver halide emulsion is of the non-prefogged type which mainly forms an internal latent image the first applied developing liquid is a surface developer. A surface developer here means that the developer used mainly develops a surface latent image and does not effect the internal latent image. Examples of developing agents contained in a surface developer are e.g. hydroquinone or p-hydroxyphenylglycine. The developing agents may also be contained in said imaging element. When the surface developing agent(s) are contained in the imaging element they may be contained in the silver halide emulsion layer, the layer containing physical development nuclei or in a separate layer in water permeable relation with one or both of these layers e.g. the intermediate hydrophylic layers described above.

During or before processing an imaging element comprising a non-prefogged direct positive type silver halide emulsion the imaging element is given a fogging treatment. This fogging treatment may be done by overall exposing the image-wise exposed imaging element or chemically by means of a fogging agent. Chemical fogging is preferred in the present invention.

The fogging agent may be contained in the first applied processing bath. Fogging agents suitable for use with the present invention are compounds capable of preferentially fogging during development processing or a pre-bath processing the surface of the silver halide grains that have no internal latent image thus making such grains developable with a surface type developer and, on the other hand, that do not form surface development centers in silver halide grains already having an internal latent image. Suitable fogging agents are e.g. boron hydride compounds, tin compounds, hydrazine derivatives as described in US-P-2588982 and US-P-2568785 e.g. hydrazine dihydrochloride, p-tolylhydrazine hydrochloride, p-nitrophenylhydrazine hydrochloride, phenylhydrazine hydrochloride, diamino biuret etc., the hydrazide derivatives described in US-P-3227552 e.g. 1-formyl-2-phenylhydrazide, 1-acetyl-2-phenylhydrazide, 1-phenylsulfonyl-2-phenylhydrazide etc., the hydrazones as described in US-P-3227552 the hydrazone quaternary salts described in US-P-3615615 e.g. 3-(2-formylethyl)-2-methylbenzothiazolium bromide, the hydrazines containing a thiourea group described in US-P-4030925 and US-P-4031127 e.g. 1-[4-(2-formylhydrazino)phenyl]-3-methylthiourea,1-[4-(2-formylhydrazino)phenyl]-2-phenylthiourea, 1-[3-N-(4-formylhydrazino-phenyl)carbamoylphenyl]-2-phenylthiourea etc., etc. , and mixtures thereof. Alternatively the fogging agent(s) may be present in one or more of the layers comprised on the support of the imaging element.

In the case that the imaging element comprises a direct positive emulsion of the pre-fogged type the first applied developing bath can be a conventionally used alkaline developing bath for developing a photographic silver halide material. Suitable developing agents are e.g. hydroquinone-type and 1-phenyl-3-pyrazolidone-type developing agents as well as p-monomethylaminophenol. The first applied processing solution usually contains alkaline substances e.g. tribasic phosphate, primary, secondary and tertiary alkanolamines or mixtures thereof as disclosed in the European patent application numbers 90201224.4, 89201253.5, 89201251.9, 89201254.3, US-P-4632896 and DE-OS-3533449, preserving agents e.g. sodium sulphite, thickening agents e.g. hydroxyethylcellulose and carboxymethylcellulose, fog-inhibiting agents e.g. potassium bromide. The pH of the processing solution is preferably in the range of 9 to 14. With respect to alkaline substances for use in the processing solution, combinations of sodium carbonate with sodium hydroxide and/or 2-methylamino-ethanol were found to be advantageous because of improved buffering action and retarded exhaustion of the processing solution. The developing agent(s) may also be comprised in one or more of the layers comprised on the support of the imaging element. When all the developing agent(s) are comprised in the imaging element the first developing liquid is merely an alkaline activating liquid.

The second applied developing liquid used in accordance with the present invention comprises at least a silver halide solvent and preferably also contains the alkaline substances described above. Suitable silver halide complexing agents are 2-mercaptobenzoic acid derivatives and cyclic imides as described in US-P-4297429 and US-P-4297430 which are included herein by reference, thiosulfates, thiocyanates, thioethers, thiazolines etc, or mixtures thereof. Of the foregoing, thiocyanates are preferred for use with the present invention.

The second applied developing liquid may further comprise developing agent(s). Suitable developing agent(s) are e.g. hydroquinone-type and 1-phenyl-3-pyrazolidone-type developing agents as well as p-monomethylaminophenol and mixtures thereof. One or more of these developing agent(s) may be comprised in one or more layers comprised on the imaging element of the present invention.

The second developing liquid may additionally comprise (a) physical development restraining compound(s) which is especially preferred when the direct positive silver halide emulsion is of the non-prefogged type. Suitable physical development restraining compounds for use according to the present invention are tetrazoles, oxazoles, thiazoles, pyrimidines, imidazoles, tetrazaindenes, pyrazoles, pyrazolone, imadazole etc. and mixtures thereof. Preferred physical development restraining compounds correspond to general formula (I) or (II): 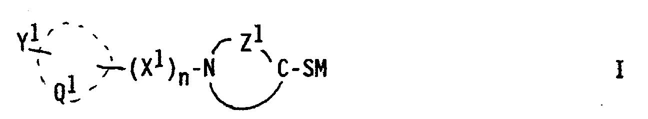 wherein M represents a metal or hydrogen, Z¹ represents a group of atoms to complete a heterocyclic ring system together with the atoms N and C including fused heterocyclic ring systems, X¹ represents an organic divalent group e.g. NR with R being a hydrogen or alkyl group, Q¹ represents a group of atoms necessary to complete an aromatic ring e.g. a phenylene group, Y¹ represents a hydrophilic group e.g. an organic acid or salt thereof e.g. a carboxylate, a sulphonate, thiosulphonate, and n may be 0 or 1. 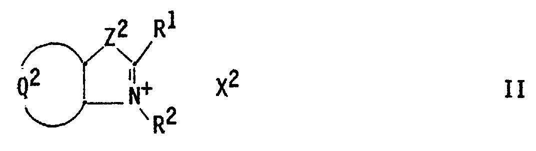 wherein each of R¹ and R² which may be the same or different represents hydrogen or an alkyl group, R¹ and R² may also together represent the necessary atoms to form a ring with the N and C atoms to which they are attached, Q² represents a group of atoms necessary to complete a fused on aromatic ring, Z² represents O or S and X² represents an anion. Examples of compounds of general formula I are: 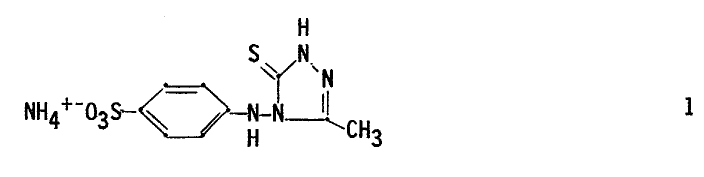 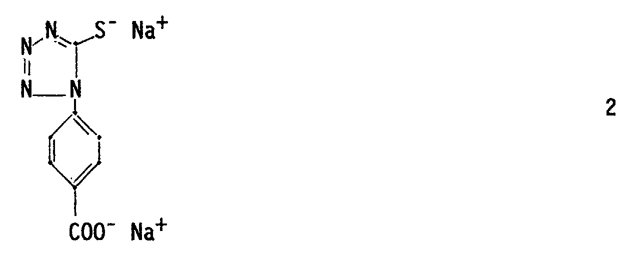 Examples of compounds corresponding to general formula (II) are:

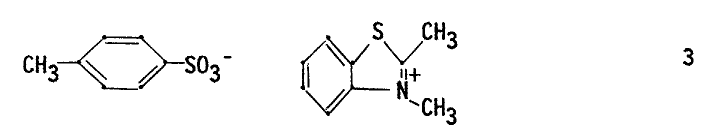

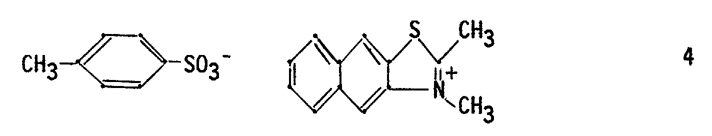

The physical development restraining compound may alternatively be comprised in one or more of the layers comprised on the support of the imaging element of the present invention.

Although the processing of the image-wise exposed imaging element is preferably done using a two bath processing both processing liquids may be merged into one processing liquid thus allowing a mono-bath processing. In this latter case the silver halide solvent may be comprised in one of the layers comprised on the support of the imaging element.

After the above described processing a silver image is obtained in the layer containing physical development nuclei. In case the support of the imaging element is aluminium it will be necessary to remove the hydrophilic layer and subsequent silver halide emulsion layers. Said removal can be accomplished by rinsing with water.

A lithographic printing plate is thus obtained carrying a oleophilic silver image on a oleophobic background. However the differentiation between the silver image and the background is often not sufficient. This differentiation can be enhanced by treating the silver image with so-called hydrophobizing agents. US-P-3,776,728 describes the use of heterocyclic mercapto-compounds, e.g. a 2-mercapto-1,3,4-oxadiazole derivative, as hydrophobizing agents. US-P-4,563,410 discloses hydrophobizing liquids containing one or more mercaptotriazole or mercaptotetrazole derivatives.

The present invention is illustrated with the following examples without limiting it thereto. All parts are by weight unless otherwise specified.

### EXAMPLE 1

| Preparation of the non-light sensitive silver halide emulsion. | | |
|---|---|---|
| Solution A (35°C): | water | 1500ml |
| | AgNO₃ | 498g |
| Solution B (35°C): | water | 1360ml |
| | NaCl | 184g |
| | KBr | 10g |
| Solution C (35°C): | water | 2250ml |
| | gelatin | 70g |
| | KBr | 3.5g |

Solution C was brought to 50°C and 30ml of a solution containing 3.9 % of Na₃RhCl₆ was added. After adjusting the pH to 3.5 solution A and B were added simultaniously to solution C in ten minutes. The resulting emulsion was precipitated by adding 85ml of a solution containing 15 % of polystyrene sulfonic acid. The precipitate was rinsed several times and redispersed by adding 180g of gelatin per 2.2kg of precipitate. The thus obtained emulsion was physically ripened for 2 hours. A non-light sensitive silver halide emulsion containing 96 mol% of silver chloride and 4mol% of silver bromide was thus obtained. The average grain size was 0.2µm.

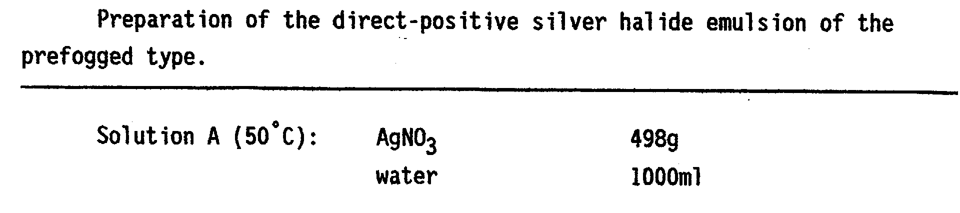

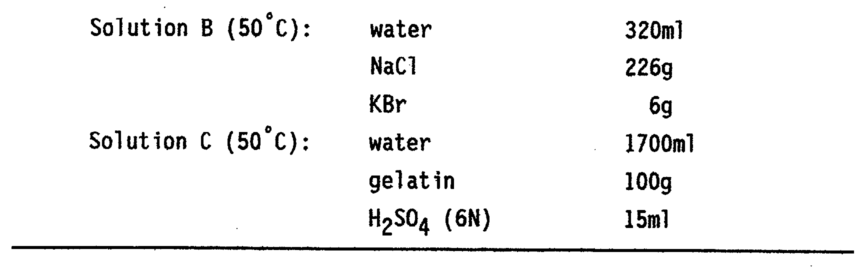

Solution A and B were simultaniously added to solution C in 3 min. Physical ripening was carried out for 25 min. at 60°C, whereafter 120ml of a 1% of potassium iodide solution where added. The resulting emulsion was precipitated by adding 65ml of a solution containing 15% of polystyrene sulfonic acid. The precipitate was rinsed several times and redispersed by adding 250g of gelatine to a final content of 150g of AgNO₃ per kg of emulsion. The pH was adjusted to 6.9-7.1 with sodium hydroxide, and the pAg was adjusted to 185-195mV with a diluted silver nitrate solution. The emulsion was subsequently fogged during 3 hours at 55°C by addition of 1.9ml 0.05% NaAuCl₄ and AuCl₃.

The emulsion was redissolved at 36 °C and treated with 144mg of pinacryptolyellow per 50g of emulsion and with 116mg of M60, another desensitizer (structure see below), per 50g of emulsion.

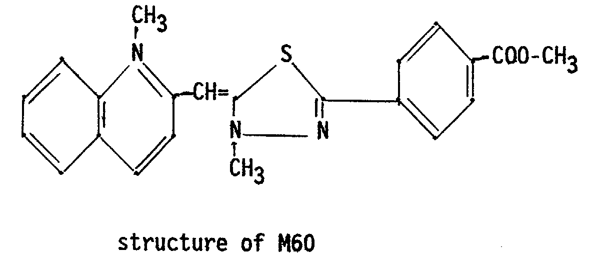

Preparation of the imaging element.

To a polyethylene terephthalate film support coated with a hydrophilic adhesion layer was coated in the order given the above described non-light sensitive silver halide emulsion in an amount of silver halide equivalent to 2g of AgNO₃/m², a separation layer of gelatin in an amount of 0.7g of gelatin per m², the above described direct positive silver halide emulsion in an amount of silver halide equivalent to 0.5g of AgNO₃/m², a finishing layer of gelatin in an amount of 0.6g gelatin per m² and a layer of PdS physical development nuclei.

Preparation of the lithographic printing plate.

The thus obtained imaging element was image-wise exposed through a negative orginal for 100s with halogen light source and subsequently processed as follows:
- 30s in a transfer developing bath with the following composition:

| | |
|---|---|
| NaOH | 30g/l |
| Na₂SO₃ | 33g/l |
| hydroquinone | 20g/l |
| 1-phenyl-4,4-dimethyl-3-pyrazolidone | 5g/l |
| Sodium salt of Ethylene Diamine Tetracetate (EDTA) | 1g/l |
| KSCN | 20g/l |
| 5-heptyl-2-mercapto-1,3,4-oxadiazole | 0.15g/l |

- 30s in a stabilising liquid with the following composition:

| | |
|---|---|
| NaH₂PO₄.2H₂O | 60g/l |
| Na₂HPO₄.12H₂O | 10g/l |
| Na₂SO₃ | 5g/l |
| Cysteine.HCl.H₂O | 1g/l |
| Ammoniumperfluorocaprylate | 0.2g/l |

The thus obtained printing plate was installed on a ABDIck 9850 printing press, inked with ABDick 1020 ink and using a conventional- foutain solution. Up to 5000 copies of good quality could be printed.

### EXAMPLE 2 (Comparison)

The same procedure as described in example 1 was followed with the only difference that the finishing layer and separation layer were left out. 1000 copies of acceptable quality could be printed.

### EXAMPLE 3

An imaging element prepared and image-wise exposed as in example 1 was processed using a two-bath processing as follows:
- 12s at roomtemperature in a developing liquid with the following composition: 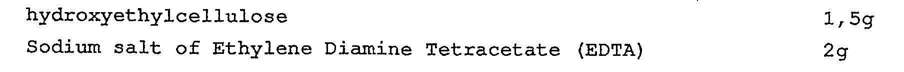 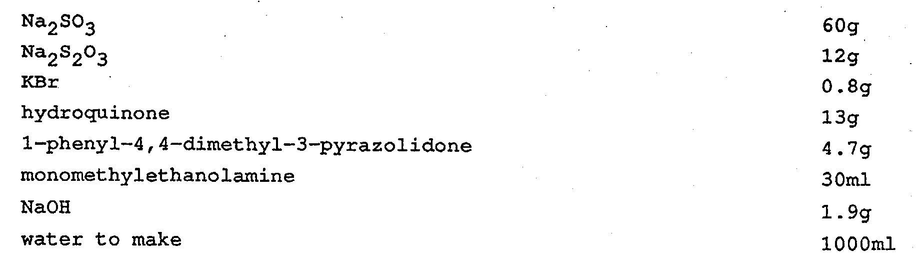
- 30s in the transfer developing liquid described in example 1
- 30s in the stabilising solution described in example 1.

The thus obtained printing plate was used to print as described in example 1. 6000 copies of good quality could be obtained.

### EXAMPLE 4 (Comparison)

The imaging element used in example 2 was image-wise exposed and subsequently processed as in example 3. With the thus obtained printing plate 1000 copies of acceptable quality could be printed according to the printing procedure described in example 1.

### EXAMPLE 5

Preparation of a direct positive silver halide emulsion of the non-prefogged type.

A gelatino silver chlorobromoiodide emulsion that mainly forms an internal latent image was prepared by conversion of a silver chlorobromide emulsion containing 19 mol% of silver bromide by very slowly adding to 1 kg of said emulsion whilst stirring 90ml of a 35% aqueous potassium bromide solution in 15 min. Said emulsion was physically ripened for 1 hour at 40°C and 100ml of a solution containing 34% of potassium bromide and 1% of potassium iodide was subsequently added. Said emulsion was subsequently cooled and washed. By heating the washed emulsion, a liquid silver chlorobromoiodide emulsion, was obtained containing 96mol% of bromide and 0.5mol% of iodide.

Preparation of the imaging element.

To a polyethylene terephthalate film support coated with a hydrophilic adhesion layer was coated in the order given the non-light sensitive silver halide emulsion layer described in example 1 in an amount of silver halide equivalent to 2g of AgNO₃ per m², a separation layer of gelatin in an amount of 0.7g/m² of gelatin, the above described direct positive silver halide emulsion of the non-prefogged type in an amount of silver halide equivalent to 0.5g of AgNO₃ per m², a finishing layer of gelatin in an amount of 0.6g/m² of gelatin and a layer of PdS physical development nuclei.

Preparation of the lithographic printing plate.

The thus obtained imaging element was image-wise exposed during 1µs using a Xenon flash. The distance between said imaging element and the Xenon flash was 58cm. The intensity of the Xenon flash was 13.8 J/cm² which was reduced using a grey filter with a density of 1.5.

The thus obtained image-wise exposed imaging element was processed for 20 s in a surface developer of the following composition:

| | |
|---|---|
| N-methyl-p-hydroxy-aniline | 30g |
| sodium sulphite | 110g |
| sodium hydroxide | 23g |
| N-methylaminoethanol | 40ml |
| EDTA | 1g |
| sodium carbonate | 40g |
| hydroquinone | 24g |
| sodium bromide | 5g |
| oxalic acid | 2g |
| 1-[[4-(2-formylhydrazino)phenyl]-aminocarbonylmethyl]-3-methyl-2-thioxo-4-imidazolidone | 0.26g |
| water to make | 1000ml |

After rinsing, said imaging element was processed for 15 s in a transfer developing solution of the following solution:

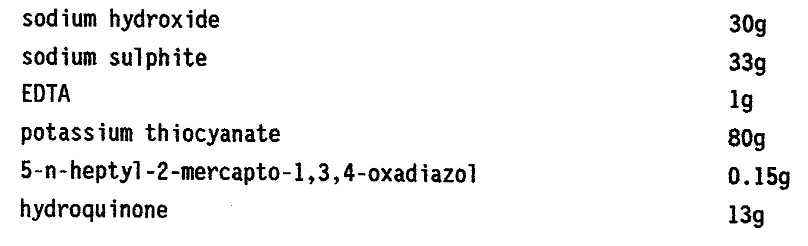

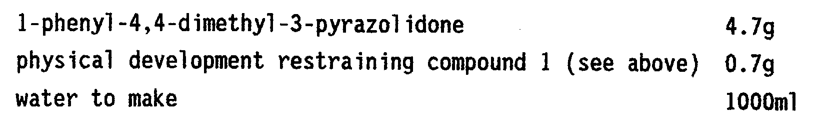

After rinsing said imaging element a lithographic printing plate was obtained. 3000 copies of good quality could be printed using a conventional fountain solution and an ABDick 1020 ink.

## Claims

1. An imaging element comprising on a support (i) a direct positive silver halide emulsion layer, (ii) a substantially non-light-sensitive layer containing a silver salt and (iii) a layer containing physical development nuclei, the said layer (i) being provided between layers (ii) and (iii), characterized in that said imaging element additionally comprises a hydrophylic layer between said direct positive silver halide emulsion layer and said substantially non-light sensitive layer and/or a hydrophilic layer between said direct positive silver halide emulsion layer and said layer of physical development nuclei.

2. An imaging element according to claim 1 wherein said hydrophilic layer is a layer of gelatin.

3. An imaging element according to claim 1 or 2 wherein said direct positive silver halide emulsion is of the pre-fogged type.

4. An imaging element according to claim 1 or 2 wherein said direct positive emulsion mainly forms an internal latent image and is not previously fogged.

5. An imaging element according to any of the above claims wherein said direct positive silver halide emulsion contains at least 30 mol% of silver bromide.

6. A method for preparing a lithographic printing plate comprising the steps of:
- image-wise exposing an imaging element comprising on a support (i) a direct positive silver halide emulsion layer, (ii) a substantially non-light sensitive layer containing a silver salt and (iii) a layer containing physical development nuclei, the said layer (i) being provided between layers (ii) and (iii),
- developing said image-wise exposed imaging element,
- dissolving said silver salt contained in said substantially non-light-sensitive layer by means of (a) silver complexing agent(s),
- allowing the thus formed silver complexes to image-wise diffuse to said layer of physical development nuclei,
- and depositing said silver complexes in said layer of physical development nuclei.
characterized in that said imaging element additionally comprises a hydrophylic layer between said direct positive silver halide emulsion layer and said substantially non-light sensitive layer and/or a hydrophilic layer between said direct positive silver halide emulsion layer and said layer of physical development nuclei.

7. A method according to claim 6 wherein said hydrophilic layer is a layer of gelatin.

8. A method according to claim 6 or 7 wherein said direct positive silver halide emulsion is of the pre-fogged type.

9. A method according to claim 6 or 7 wherein said direct positive silver halide emulsion is a direct positive type silver halide emulsion that mainly forms an internal latent image and is not previously fogged.

10. A method according to any of the claims 6 to 9 wherein said direct positive type silver halide emulsion contains at least 30 mol% of silver bromide.

11. A method according to any of the claims 6 to 10 wherein said developing step is carried out using two developing liquids of which only the second applied developing liquid comprises a silver halide complexing agent.

## Patentansprüche

1. Ein Bilderzeugungselement, das auf einem Träger (i) eine Direktpositivsilberhalogenidemulsionsschicht, (ii) eine wesentlich lichtunempfindliche, ein Silbersalz enthaltende Schicht und (iii) eine physikalische Entwicklungskeime enthaltende Schicht enthält, wobei die Schicht (i) zwischen den Schichten (ii) und (iii) eingearbeitet ist, dadurch gekennzeichnet, daß das Bilderzeugungselement zwischen der Direktpositivsilberhalogenidemulsionsschicht und der wesentlich lichtunempfindlichen Schicht und/oder zwischen der Direktpositivsilberhalogenidemulsionsschicht und der physikalische Entwicklungskeime enthaltenden Schicht zusätzlich eine hydrophile Schicht enthält.

2. Bilderzeugungselement nach Anspruch 1, dadurch gekennzeichnet, daß die hydrophile Schicht eine Gelatineschicht ist.

3. Bilderzeugungselement nach Anspruch 1 oder 2, dadurch gekennzeichnet, daß die Direktpositivsilberhalogenidemulsion vom vorverschleierten Typ ist.

4. Bilderzeugungselement nach Anspruch 1 oder 2, dadurch gekennzeichnet, daß die Direktpositivemulsion hauptsächlich ein Innenlatentbild bildet und nicht vorverschleiert ist.

5. Bilderzeugungselement nach irgendeinem der vorstehenden Ansprüche, dadurch gekennzeichnet, daß die Direktpositivsilberhalogenidemulsion wenigstens 30 mol-% Silberbromid enthält.

6. Ein Verfahren zur Herstellung einer lithografischen Druckplatte, das die folgenden Stufen umfaßt :
- die bildmäßige Belichtung eines Bilderzeugungselements, das auf einem Träger (i) eine Direktpositivsilberhalogenidemulsionsschicht, (ii) eine wesentlich lichtunempfindliche, ein Silbersalz enthaltende Schicht und (iii) eine physikalische Entwicklungskeime enthaltende Schicht enthält, wobei die Schicht (i) zwischen den Schichten (ii) und (iii) eingearbeitet ist,
- die Entwicklung des bildmäßig belichteten Bilderzeugungselements,
- das Auflösen des in der wesentlich lichtunempfindlichen Schicht enthaltenen Silbersalzes mittels eines oder mehrerer Komplexiermittel,
- das bildmäßig Überdiffundieren der so gebildeten Silberkomplexe in die physikalische Entwicklungskeime enthaltende Schicht,
- und das Fällen der Silberkomplexe in der physikalische Entwicklungskeime enthaltenden Schicht,
dadurch gekennzeichnet, daß das Bilderzeugungselement zwischen der Direktpositivsilberhalogenidemulsionsschicht und der wesentlich lichtunempfindlichen Schicht und/oder zwischen der Direktpositivsilberhalogenidemulsionsschicht und der eine physikalische Entwicklungskeime enthaltenden Schicht eine hydrophile Schicht enthält.

7. Verfahren nach Anspruch 6, dadurch gekennzeichnet, daß die hydrophile Schicht eine Gelatineschicht ist.

8. Verfahren nach Anspruch 6 oder 7, dadurch gekennzeichnet, daß die Direktpositivsilberhalogenidemulsion vom vorverschleierten Typ ist.

9. Verfahren nach Anspruch 6 oder 7, dadurch gekennzeichnet, daß die Direktpositivsilberhalogenidemulsion eine Direktpositivsilberhalogenidemulsion ist, die hauptsächlich ein Innenlatentbild bildet und nicht vorverschleiert ist.

10. Verfahren nach irgendeinem der Ansprüche 6 bis 9, dadurch gekennzeichnet, daß die Direktpositivsilberhalogenidemulsion wenigstens 30 mol-% Silberbromid enthält.

11. Verfahren nach irgendeinem der Ansprüche 6 bis 10, dadurch gekennzeichnet, daß die Entwicklungsstufe unter Anwendung von zwei Entwicklerflüssigkeiten, von denen nur die zweite ein Silberhalogenidkomplexiermittel enthält, durchgeführt wird.

## Revendications

1. Elément formateur d'image comprenant sur un support (i) une couche d'émulsion autopositive à l'halogénure d'argent, (ii) une couche essentiellement non photosensible contenant un sel d'argent et (iii) une couche contenant des germes de développement physique, ladite couche (i) étant prévue entre les couches (ii) et (iii), caractérisé en ce que ledit élément formateur d'image comprend en outre une couche hydrophile entre ladite couche d'émulsion autopositive à l'halogénure d'argent et ladite couche essentiellement non photosensible et/ou une couche hydrophile entre ladite couche d'émulsion autopositive à l'halogénure d'argent et ladite couche de germes de développement physique.

2. Elément formateur d'image selon la revendication 1, dans lequel ladite couche hydrophile est une couche de gélatine.

3. Elément formateur d'image selon la revendication 1 ou 2, dans lequel ladite émulsion autcpositive à l'halogénure d'argent est du type prévoilé.

4. Elément formateur d'image selon la revendication 1 ou 2, dans lequel ladite émulsion autopositive forme principalement une image latente interne et n'a pas été voilée au préalable.

5. Elément formateur d'image selon l'une quelconque des revendications ci-dessus, dans lequel ladite émulsion autopositive à l'halogénure d'argent contient du bromure d'argent à concurrence d'au moins 30 moles %.

6. Procédé pour préparer un cliché lithographique, comprenant les étapes consistant à:
- exposer en forme d'image un élément formateur d'image comprenant sur un support (i) une couche d'émulsion autopositive à l'halogénure d'argent, (ii) une couche essentiellement non photosensible contenant un sel d'argent et (iii) une couche contenant des germes de développement physique, ladite couche (i) étant prévue entre les couches (ii) et (iii),
- développer ledit élément formateur d'image exposé en forme d'image,
- dissoudre ledit sel d'argent contenu dans ladite couche essentiellement non photosensible au moyen d'un ou de plusieurs agents complexant l'argent,
- laisser les complexes d'argent ainsi formés diffuser en forme d'image dans ladite couche de germes de développement physique, et
- déposer lesdits complexes d'argent dans ladite couche de germes de développement physique,
caractérisé en ce que ledit élément formateur d'image comprend en outre une couche hydrophile entre ladite couche d'émulsion autopositive à l'halogénure d'argent et ladite couche essentiellement non photosensible et/ou une couche hydrophile entre ladite couche d'émulsion autopositive à l'halogénure d'argent et ladite couche de germe de développement physique.

7. Procédé selon la revendication 6, dans lequel ladite couche hydrophile est une couche de gélatine.

8. Procédé selon la revendication 6 ou 7, dans lequel ladite émulsion autopositive à l'halogénure d'argent est du type prévoilé.

9. Procédé selon la revendication 6 ou 7, dans lequel ladite émulsion autopositive est une émulsion à l'halogénure d'argent de type autopositif qui forme principalement une image latente interne et qui n'a pas été voilée au préalable.

10. Procédé selon l'une quelconque des revendications 6 à 9, dans lequel ladite émulsion autopositive à l'halogénure d'argent contient du bromure d'argent à concurrence d'au moins 30 moles %.

11. Procédé selon l'une quelconque des revendications 6 à 10, dans lequel on effectue ladite étape de développement en utilisant deux liquides de développement, seul le second liquide de développement appliqué comprenant un agent ccmplexant l'halogénure d'argent.
